# EUROPÄISCHE PATENTSCHRIFT

(11) **EP 3 568 871 B1**
(45) Veröffentlichungstag und Bekanntmachung des Hinweises auf die Patenterteilung: **04.05.2022**
(21) Anmeldenummer: 18700663.0
(22) Anmeldetag: 15.01.2018
(51) Int. Cl.: H01L 21/67, G01R 1/04

(54) **VORRICHTUNG ZUM TEMPERIEREN EINES SUBSTRATS UND ENTSPRECHENDES HERSTELLUNGSVERFAHREN**
APPARATUS FOR ANNEALING A SUBSTRATE AND CORRESPONDING MANUFACTURING PROCESS
APPAREIL POUR RECUIT D'UN SUBSTRAT ET

(30) Priorität: 16.01.2017 DE 102017200588
(43) Veröffentlichungstag der Anmeldung: 20.11.2019
(73) Patentinhaber: ERS electronic GmbH, 82110 Germering (DE)
(72) Erfinder: REITINGER, Klemens, 82100 Germering (DE)
(74) Vertreter: Isarpatent
(86) Internationale Anmeldenummer: PCT/EP2018/050874
(87) Internationale Veröffentlichungsnummer: WO 2018/130684

(56) Entgegenhaltungen:
- EP-B1- 1 943 665
- JP-A- 2002 129 331
- US-A1- 2002 145 439
- US-A1- 2005 155 555
- US-A1- 2007 039 942
- US-A1- 2007 235 134
- US-A1- 2013 284 372
- US-A1- 2014 311 728

## Beschreibung

Die vorliegende Erfindung betrifft eine Vorrichtung zum Temperieren eines Substrats, insbesondere eines Wafersubstrats, und ein entsprechendes Herstellungsverfahren.

Obwohl nicht darauf beschränkt, werden die vorliegende Erfindung und die ihr zugrundeliegende Problematik anhand von integrierten Schaltungen auf Waferebene erörtert.

Im Fertigungsablauf bei der Produktion von integrierten Schaltungen werden Wafertests an noch nicht zerteilten Wafern durchgeführt, um fehlerhafte integrierte Schaltungen frühzeitig erkennen und aussondern zu können. Dafür wird ein zu testender Wafer in einen Wafer-Prober eingelegt und mittels eines darin befindlichen temperierbaren Chucks (Vorrichtung zum Temperieren des Wafersubstrats) auf eine gewünschte Testtemperatur gebracht. Wenn sich der Wafer auf der gewünschten Testtemperatur befindet, wird mittels einer Kontaktnadelanordnung, die sich an einem Nadelkopf befindet, eine elektrische Verbindung zu den Kontaktflächen der zu testenden integrierten Schaltung erstellt. Der Nadelkopf mit den Kontaktnadeln ist auf einer sogenannten Probecard angebracht, welche eine Schnittstelle zwischen einem Testsystem und dem Wafer über die Kontaktnadeln des Nadelkopfes bildet.

Wafertests werden typischerweise im Temperaturbereich zwischen -40 °C und 200 °C durchgeführt, in Ausnahmefällen sogar bei noch extremeren Temperaturen oberhalb bzw. unterhalb des Nullpunkts.

Herkömmliche Vorrichtungen zum Temperieren eines Substrats, insbesondere eines Wafersubstrats, sind mit einem geschlossenen Kühlkreislauf versehen, bei dem ein Kühlfluid durch Kanäle in der Substrathaltevorrichtung zu einem Wärmetauscher und wieder zurück zur Substrathaltevorrichtung zirkuliert.

Die EP 1 943 665 B1 offenbart eine Vorrichtung zum Temperieren eines Substrats, insbesondere eines Wafers, wobei die Vorrichtung einen durch eine erste Temperiereinrichtung und eine zweite Temperiereinrichtung temperierten Hauptkörper aufweist, wobei die erste Temperiereinrichtung zur Temperierung des Hauptkörpers in einem ersten Temperaturbereich zwischen einer ersten Temperatur und einer zweiten Temperatur konfiguriert ist, wobei die erste Temperatur niedriger als die zweite Temperatur ist, und mittels eines ersten Temperierfluids temperiert wird, und die zweite Temperiereinrichtung zur Temperierung des Hauptkörpers in einem zweiten Temperaturbereich zwischen einer dritten Temperatur und einer vierten Temperatur konfiguriert ist, wobei die dritte Temperatur niedriger als die vierte Temperatur ist, und die zweite Temperiereinrichtung mittels eines zweiten Temperierfluids temperiert wird, wobei die zweite Temperatur niedriger als die vierte Temperatur ist und sich das erste Temperierfluid vom zweiten Temperierfluid unterscheidet. Der Hauptkörper weist eine im wesentlichen planare Anlagefläche mit einer Befestigungseinrichtung zum Befestigen eines Substrats auf, die eine Vielzahl von Ansaugrillen aufweist, wobei im Inneren des darüberliegenden Hauptkörpers ein oder mehrere erste Temperiermittelkanäle für das erste Temperierfluid vorgesehen sind, und wobei die zweite Temperiereinrichtung zur Temperierung des Hauptkörpers einen Temperierkörper umfasst, der in seinem Inneren ein oder mehrere zweite Temperiermittelkanäle für das zweite Temperierfluid aufweist.

Als nachteilhaft bei dieser bekannten Vorrichtung zum Temperieren eines Substrats hat sich herausgestellt, dass sie aufgrund der übereinanderliegenden Temperiereinrichtungen großvolumig ist und dass die untere Temperiereinrichtung weit weg vom Substrat angeordnet ist.

Außerdem kennt man aus der US 2007/0235134 A1, der US 2013/0284372 A1, der EP2088616 A2 und der US2004/0187787 A1 und der US 2007/0039942 A1 weitere Vorrichtungen zur Temperatursteuerung bei der Herstellung von Werkstücken in Prozesskammern, etwa von Wafersubstraten.

Daher ist es Aufgabe der vorliegenden Erfindung, eine Vorrichtung zum Temperieren eines Substrats, welche kompakter gestaltbar ist, und ein entsprechendes Herstellungsverfahren bereitzustellen.

Zur Lösung dieser Aufgabe schafft die vorliegende Erfindung eine Vorrichtung zum Temperieren eines Substrats nach Anspruch 1 und ein entsprechendes Herstellungsverfahren nach Anspruch 14.

Bevorzugte Weiterbildungen sind Gegenstand der jeweiligen abhängigen Ansprüche.

Die der vorliegenden Erfindung zugrunde liegende Idee besteht darin, zwei unterschiedliche Temperierungseinrichtungen in den Hauptkörper platzsparend und einfach anschließbar einzubetten. Insbesondere lassen sich bei der erfindungsgemäßen Vorrichtung zum Temperieren eines Substrats die jeweiligen Entfernungen der Temperierungseinrichtungen zum Substrat etwa gleich einstellen.

Gemäß einer weiteren bevorzugten Weiterbildung weist der Hauptkörper einen plattenförmigen Unterteil und einen plattenförmigen Oberteil auf, welche in einem Verbindungsbereich miteinander verbunden, insbesondere verlötet oder verklebt, sind. Dies vereinfacht das Herstellungsverfahren.

Gemäß einer weiteren bevorzugten Ausführungsform sind die erste bis vierte Bohrung im Unterteil und die erste Mehrzahl getrennter ringförmiger Kanäle und die zweite Mehrzahl getrennter ringförmiger Kanäle im Oberteil vorgesehen. So lassen sich die Röhren vor dem Zusammenbau des Oberteils und des Unterteils einsetzen.

Gemäß einer weiteren bevorzugten Ausführungsform sind die erste Mehrzahl getrennter ringförmiger Kanäle und die zweite Mehrzahl getrennter ringförmiger Kanäle konzentrisch zu einer Mittelachse des Hauptkörpers, vorzugsweise kreisförmig, angeordnet.

Die erste Mehrzahl getrennter ringförmiger Kanäle und die zweite Mehrzahl getrennter ringförmiger Kanäle sind einander umgreifend alternierend angeordnet. So kann durch beide Temperierungseinrichtungen eine homogene Temperaturverteilung erreicht werden.

Gemäß einer weiteren bevorzugten Ausführungsform weisen die erste Mehrzahl getrennter ringförmiger Kanäle und die zweite Mehrzahl getrennter ringförmiger Kanäle jeweilige unterschiedliche Querschnitte auf. So lassen sich unterschiedliche Viskositäten der beiden Temperierungsfluide, z.B. Gas/Flüssigkeit, berücksichtigen.

Gemäß einer weiteren bevorzugten Ausführungsform sind die erste bis vierte Röhre mit dem Hautkörper verlötet oder verklebt. Dies gewährleistet eine hohe Dichtigkeit beider Kreisläufe.

Gemäß einer weiteren bevorzugten Ausführungsform sind die erste bis vierte Röhre aus Edelstahl, Kupfer oder einem Kunststoff hergestellt.

Gemäß einer weiteren bevorzugten Ausführungsform ist der Hauptkörper aus Kupfer oder Aluminium hergestellt. Dies sorgt für eine hohe Wärmeleitfähigkeit. Für bestimmte Anwendungen wären auch thermisch hoch leitfähige keramische Werkstoffe denkbar.

Gemäß einer weiteren bevorzugten Ausführungsform sind die ersten Öffnungen und die zweiten Öffnungen paarweise derart angeordnet, dass sie mit dem jeweiligen ringförmigen Kanal an zwei Orten kommunizieren, welche im Uhrzeigersinn und im Gegenuhrzeigersinn entlang des jeweiligen ringförmigen Kanals ungefähr gleichweit beabstandet sind. Dies sorgt für eine homogene Temperaturverteilung.

Gemäß einer weiteren bevorzugten Ausführungsform sind die dritten Öffnungen und die vierten Öffnungen paarweise derart angeordnet, dass sie mit dem jeweiligen ringförmigen Kanal an zwei Orten kommunizieren, welche im Uhrzeigersinn und im Gegenuhrzeigersinn entlang des jeweiligen ringförmigen Kanals ungefähr gleichweit beabstandet sind. Dies sorgt für eine homogene Temperaturverteilung.

Gemäß einer weiteren bevorzugten Ausführungsform weisen die erste und/oder zweite und/oder dritte und/oder vierte Röhre ein erstes offenes Ende und ein zweites geschlossenes Ende auf, wobei die Öffnungen einen vom ersten offenen Ende zum zweiten geschlossenen Ende hin ansteigenden Querschnitt aufweisen. So lässt sich der über den Röhren auftretende Druckabfall kompensieren.

Gemäß einer weiteren bevorzugten Ausführungsform weisen die erste und/oder zweite und/oder dritte und/oder vierte Röhre mehrere Öffnungen pro ringförmigen Kanal auf. So lassen sich die jeweiligen Einström- bzw. Ausströmrichtungen einstellen, insbesondere die Temperaturverteilungen homogenisieren.

Gemäß einer weiteren bevorzugten Ausführungsform sind die mehreren Öffnungen in gegenüberliegende Richtungen des zugehörigen ringförmigen Kanals ausgerichtet. Dies führt zu einer thermodynamisch besonders effektiven Gegenstromeinströmung bzw. - ausströmung.

Ausführungsbeispiele der Erfindung sind in den Zeichnungen dargestellt und in der nachfolgenden Beschreibung näher erläutert.

Es zeigen:
- Fig. 1: schematische ebene Querschnittsdarstellung einer Vorrichtung zum Temperieren eines Substrats gemäß einer ersten Ausführungsform der vorliegenden Erfindung;
- Fig. 2: eine teilweise senkrechte Querschnittsdarstellung der Vorrichtung zum Temperieren eines Substrats gemäß der ersten Ausführungsform der vorliegenden Erfindung entlang der Linie X_X' in Fig. 1;
- Fig. 3a),b): jeweilige axiale Querschnittsdarstellungen der ersten und zweiten Röhre der Vorrichtung zum Temperieren eines Substrats gemäß der ersten Ausführungsform der vorliegenden Erfindung;
- Fig. 4a),b): jeweilige teilweise senkrechte Querschnittsdarstellungen der Vorrichtung zum Temperieren eines Substrats gemäß der ersten Ausführungsform der vorliegenden Erfindung im Bereich der Öffnungen F1 und L3 zum Einleiten des ersten bzw. zweiten Temperierungsfluids;
- Fig. 4c),d): jeweilige teilweise senkrechte Querschnittsdarstellungen der Vorrichtung zum Temperieren eines Substrats gemäß der ersten Ausführungsform der vorliegenden Erfindung im Bereich der Öffnungen F1 und L3' zum Ableiten des ersten bzw. zweiten Temperierungsfluids;
- Fig. 5: ein axiale Querschnittsdarstellung der ersten Röhre der Vorrichtung zum Temperieren eines Substrats gemäß einer zweiten Ausführungsform der vorliegenden Erfindung; und
- Fig. 6: eine teilweise senkrechte Querschnittsdarstellung der Vorrichtung zum Temperieren eines Substrats gemäß einer dritten Ausführungsform der vorliegenden Erfindung im Bereich der Öffnungen F11 und L12 zum Einleiten des ersten Temperierungsfluids.

In den Figuren bezeichnen gleiche Bezugszeichen gleiche oder funktionsgleiche Bestandteile.

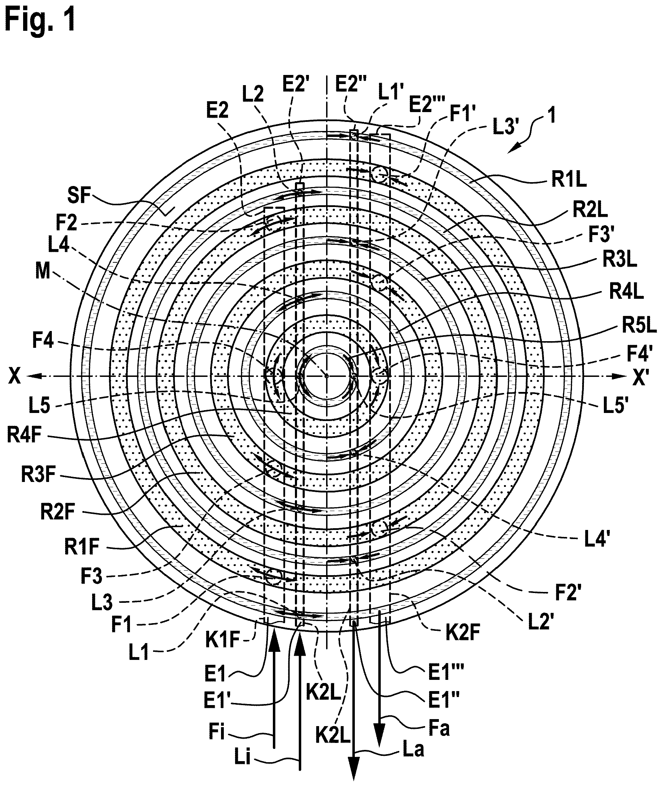

Fig. 1 ist eine schematische ebene Querschnittsdarstellung einer Vorrichtung zum Temperieren eines Substrats gemäß einer ersten Ausführungsform der vorliegenden Erfindung.

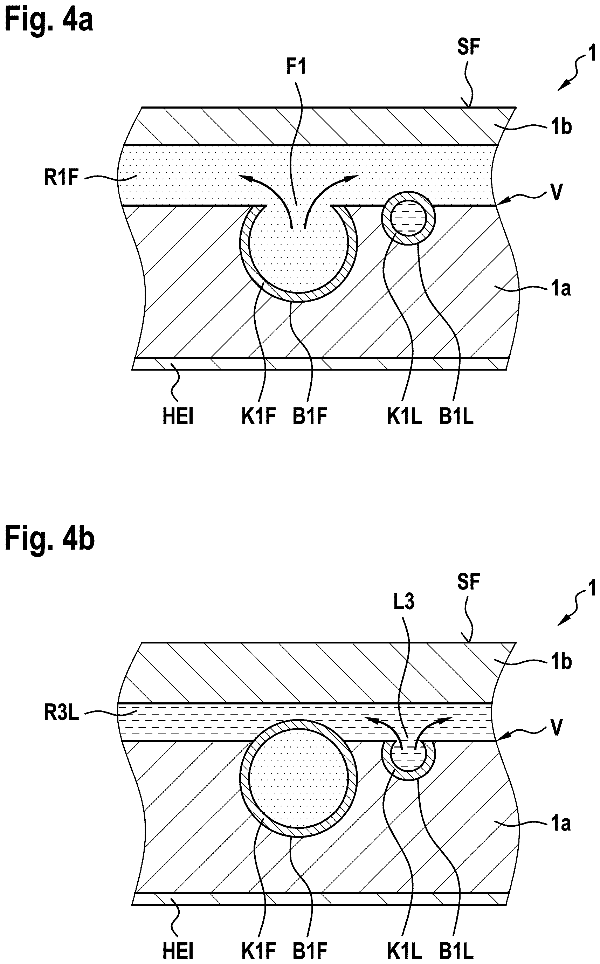

In Fig. 1 bezeichnet Bezugszeichen 1 einen plattenförmigen Hauptkörper mit einer Substratauflagefläche SF, welcher einen plattenförmigen Unterteil 1a und einen plattenförmigen Oberteil 1b aufweist, die in einem Verbindungsbereich V (vgl. Fig. 4a)-b)) miteinander verbunden sind, beispielsweise durch Verlöten oder Verkleben. Die Substratauflagefläche SF kann (nicht dargestellte) Rillen aufweisen, welche mit einer (nicht dargestellten) Unterdruckerzeugungsvorrichtung verbunden sind, um so zum Stabilisieren des aufgelegten Substrats, beispielsweise eines Wafersubstrats, zu dienen.

Vorgesehen im Innern des plattenförmigen Hauptkörper 1 ist eine erste Temperierungseinrichtung zum Temperieren des Hauptkörpers mittels eines ersten Temperierungsfluids, beispielsweise einer Flüssigkeit, welche eine erste Mehrzahl getrennter umlaufender ringförmiger Kanäle R1F-R4F im Inneren des Hauptkörpers 1 zum Zirkulieren des ersten Temperierungsfluids aufweist, wobei R1F einen ersten Kanal, R2F einen zweiten Kanal, R3F einen dritten Kanal und R4F einen vierten Kanal der ersten Mehrzahl bezeichnet.

Weiterhin vorgesehen im Inneren des Hauptkörpers 1 ist eine zweite Temperierungseinrichtung zum Temperieren des Hauptkörpers 1 mittels eines zweiten Temperierungsfluids, beispielsweise eines Gases, welche eine zweite Mehrzahl getrennter ringförmiger Kanäle R1L-R5L im Inneren des Hauptkörpers 1 zum Zirkulieren des zweiten Temperierungsfluids aufweist, wobei R1L einen ersten Kanal, R2L einen zweiten Kanal, R3L einen dritten Kanal, R4L einen vierten Kanal und R5L einen fünften Kanal der zweiten Mehrzahl bezeichnet.

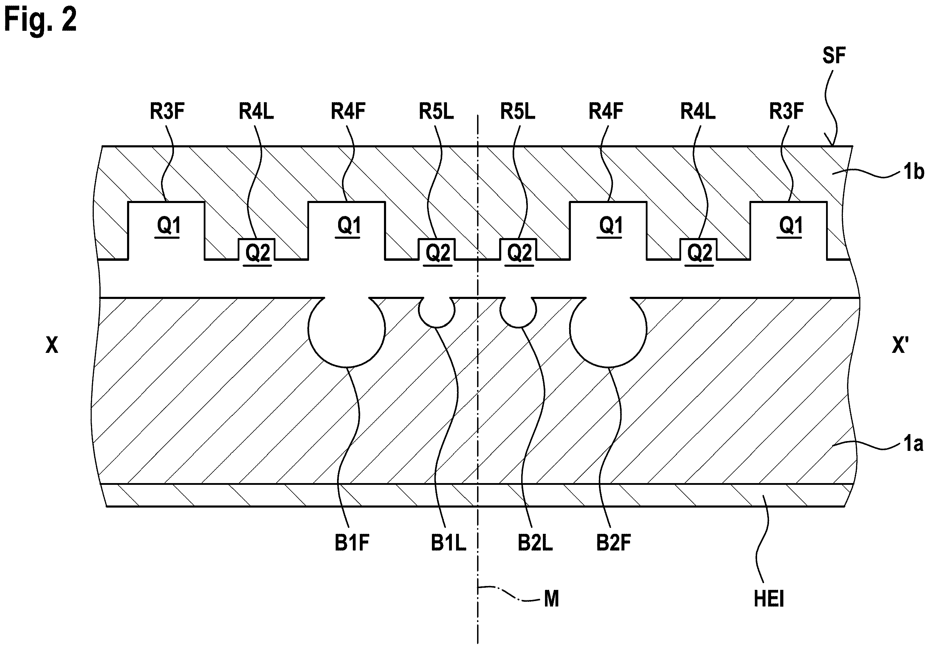

Der ersten Mehrzahl ringförmiger Kanäle R1F-R4F ist das erste Temperierungsfluid durch eine erste Röhre K1F zuführbar und durch eine zweite Röhre K2F daraus ableitbar. Die erste Röhre K1F und die zweite Röhre K2F sind in eine entsprechende erste Bohrung B1F und eine entsprechende zweite Bohrung B2F des Hauptkörpers 1 eingesetzt (vgl. Fig. 2). Der zweiten Mehrzahl ringförmiger Kanäle R1L-R5L ist das zweite Temperierungsfluid durch eine dritte Röhre K1L zuführbar und durch eine vierte Röhre K2L daraus ableitbar. Die dritte Röhre K1L und die vierte Röhre K2L sind in eine entsprechende dritte Bohrung B1L und vierte Bohrung B2L im Hauptkörper 1 eingesetzt (vgl. Fig. 2).

Der Eingang Fi für das erste Temperierungsfluid befindet sich an einem ersten offenen Ende E1 der ersten Röhre K1F, welche weiterhin ein zweites geschlossenes Ende E2 aufweist. Der Ausgang Fa für das erste Temperierungsfluid befindet sich an einem ersten offenen Ende E1‴ der zweiten Röhre K2F, welche weiterhin ein zweites geschlossenes Ende E2‴ aufweist.

Der Eingang Li für das zweite Temperierungsfluid befindet sich an dem ersten offenen Ende E1' der dritten Röhre K1L, welche weiterhin ein zweites geschlossenes Ende E2' aufweist. Der Ausgang La für das zweite Temperierungsfluid befindet sich an einem ersten offenen Ende E1" der vierten Röhre K2L, welche weiterhin ein zweites geschlossenes Ende E2" aufweist.

Die erste bis vierte Röhre K1F, K2F, K1L, K2L sind zweckmäßigerweise zusätzlich dichtend mit dem Hauptkörper 1 verbunden, beispielsweise durch Kleben oder Löten.

Die erste bis vierte Röhre K1F, K2F, K1L, K2L ragen zweckmäßigerweise derart seitlich aus dem Hauptkörper 1 hervor, dass entsprechende Anschlüsse, z.B. (nicht dargestellte) Flansche, daran angebracht werden können, welche mit entsprechenden Quellen bzw. Senken für das erste bzw. zweite Temperierungsfluid verbunden sind.

Die erste bis vierte Bohrung B1F, B2F, B1L, B2L, die im vorliegenden Beispiel jeweils als Sackbohrung ausgeführt sind, kommunizieren jeweils mit der ersten Mehrzahl getrennter ringförmiger Kanäle R1F-R4F und der zweiten Mehrzahl getrennter ringförmiger Kanäle R1L-R5L, d.h. sie sind dorthin offen.

Die erste Röhre K1F, die in die erste Bohrung B1F des Hauptkörpers 1 eingesetzt ist, weist jeweilige erste Öffnungen F1-F4 im Bereich der ersten Mehrzahl getrennter ringförmiger Kanäle R1F-R4F zum Zuführen des ersten Temperierungsfluids auf, wobei F1 eine erste Öffnung, F2 eine zweite Öffnung, F3 eine dritte Öffnung und F4 eine vierte Öffnung der ersten Öffnungen F1-F4 bezeichnet

Die zweite Röhre K2F, die in die zweite Bohrung B2F des Hauptkörpers 1 eingesetzt ist, weist jeweilige zweite Öffnungen F1'-F4' im Bereich der ersten Mehrzahl getrennter ringförmiger Kanäle R1F-R4F zum Abführen des ersten Temperierungsfluids auf, wobei F1'eine erste Öffnung, F2' eine zweite Öffnung, F3' eine dritte Öffnung und F4' eine vierte Öffnung der zweiten Öffnungen F1'-F4' bezeichnet

Die dritte Röhre K1L, die in die dritte Bohrung B1L des Hauptkörpers 1 eingesetzt ist, weist jeweilige dritte Öffnungen L1-L5 im Bereich der zweiten Mehrzahl getrennter ringförmiger Kanäle R1L-R5L zum Zuführen des zweiten Temperierungsfluids auf, wobei L1 eine erste Öffnung, L2 eine zweite Öffnung, L3 eine dritte Öffnung, L4 eine vierte Öffnung und L5 eine fünfte Öffnung der dritten Öffnungen L1-L5 bezeichnet.

Die vierte Röhre K2L, die in die vierte Bohrung B2L des Hauptkörpers 1 eingesetzt ist, weist jeweilige vierte Öffnungen L1'-L5' im Bereich der zweiten Mehrzahl getrennter ringförmiger Kanäle R1L-R5L zum Abführen des zweiten Temperierungsfluids auf, wobei L1' eine erste Öffnung, L2' eine zweite Öffnung, L3' eine dritte Öffnung, L4' eine vierte Öffnung und L5' eine fünfte Öffnung der vierten Öffnungen L1'-L5' bezeichnet.

Beim vorliegenden Beispiel sind die erste Mehrzahl getrennter ringförmiger Kanäle R1F-R4F und die zweite Mehrzahl getrennter ringförmiger Kanäle R1L-R5L kreisförmig konzentrisch zu einer Mittelachse M des Hauptkörpers 1 angeordnet. Dabei sind die erste Mehrzahl getrennter ringförmiger Kanäle R1F-R4F und die zweite Mehrzahl getrennter ringförmiger Kanäle R1L-R5L einander umgreifend alternierend angeordnet, sodass eine möglichst homogene Temperaturverteilung erzielbar ist.

Die erste bis vierte Röhre K1F, K2F, K1L, K2L sind vorzugsweise aus Edelstahl, Kupfer oder einem Kunststoff hergestellt, wobei der Hauptkörper 1 vorzugsweise aus Kupfer oder Aluminium hergestellt ist.

Die ersten Öffnungen F1-F4 und die zweiten Öffnungen Fl'-F4' sind paarweise derart angeordnet, dass sie mit dem jeweiligen ringförmigen Kanal R1F-R4F an zwei Orten kommunizieren, welche im Uhrzeigersinn und im Gegenuhrzeigersinn entlang des jeweiligen ringförmigen Kanals R1F-R4F ungefähr gleich weit beabstandet sind, d.h., bei der vorliegenden kreisförmigen Geometrie liegen sie ungefähr diametral gegenüber. Die dritten Öffnungen L1-L5 und die vierten Öffnungen L1'-L5' sind paarweise derart angeordnet, dass sie mit dem jeweiligen ringförmigen Kanal R1L-R5L an zwei Orten kommunizieren, welche im Uhrzeigersinn und im Gegenuhrzeigersinn entlang des jeweiligen ringförmigen Kanals R1L-R5L ungefähr gleich weit beabstandet sind, d.h. sie liegen bei der vorliegenden ringförmigen Geometrie ungefähr diametral gegenüber.

Damit ergibt sich ein gegenläufiges, im wesentlichen symmetrisches Strömungsprofil des ersten und zweiten Temperierungsfluids.

Fig. 2 ist eine teilweise senkrechte Querschnittsdarstellung der Vorrichtung zum Tem-perieren eines Substrats gemäß der ersten Ausführungsform der vorliegenden Erfindung entlang der Linie X_X' in Fig. 1.

Wie aus Fig. 2 ersichtlich, sind beim vorliegenden Ausführungsbeispiel die erste bis vierte Bohrung B1F, B2F, B1L, B2L im Unterteil la und die erste Mehrzahl getrennter ringförmiger Kanäle R1F-R4F sowie die zweite Mehrzahl getrennter ringförmiger Kanäle R1L-R5L im Oberteil 1b vorgesehen. Die erste Mehrzahl getrennter ringförmiger Kanäle R1F-R4F sind rechteckig und weisen einen ersten Querschnitt Q1 auf, und die zweite Mehrzahl getrennter ringförmiger Kanäle R1L-R5L sind rechteckig und weisen einen zweiten Querschnitt Q2 auf, wobei der zweite Querschnitt Q2 kleiner als der erste Querschnitt ist. Dies trägt der Tatsache Rechnung, dass das erste Temperierungsfluid, hier eine Flüssigkeit, und das zweite Temperierungsfluid, hier ein Gas, unterschiedliche Viskositäten aufweisen.

Wie weiterhin aus Fig. 2 ersichtlich, ist weiterhin eine plattenförmige Heizeinrichtung HEI am Unterteil 1a des Hauptkörpers 1 vorgesehen, beispielsweise mit einem elektrischen Heizmechanismus.

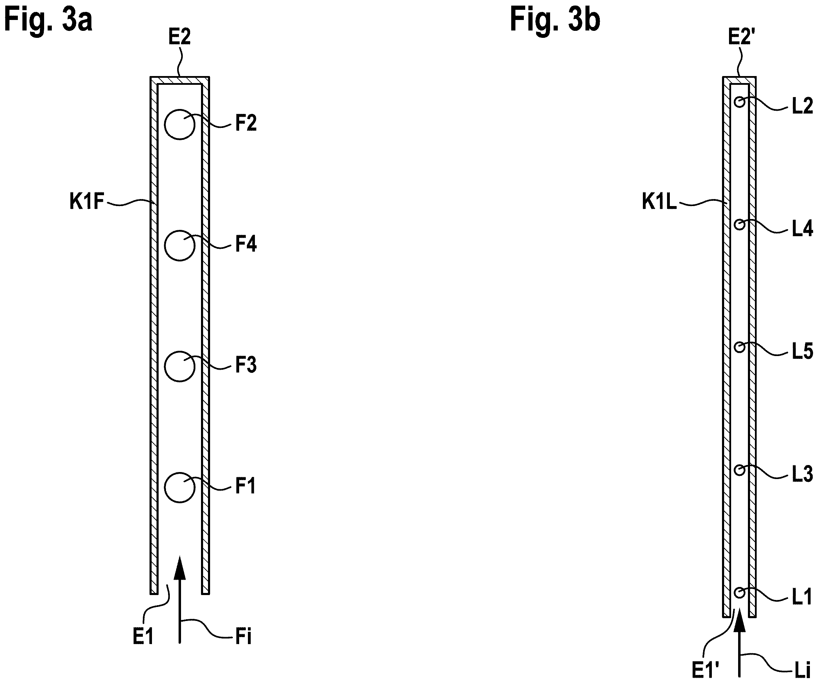

Fig. 3a),b) sind jeweilige axiale Querschnittsdarstellungen der ersten und zweiten Röhre der Vorrichtung zum Temperieren eines Substrats gemäß der ersten Ausführungsform der vorliegenden Erfindung.

Fig. 3a), b) verdeutlichen die erste Röhre K1F und die dritte Röhre K1L im nicht in den Hauptkörper 1 eingesetzten Zustand. Wie insbesondere erkennbar, sind die Querschnitte der ersten Öffnungen F1-F4 identisch, wie auch die Querschnitte der dritten Öffnungen L1-L5. Jedoch sind die Querschnitte der ersten Öffnungen F1-F4 größer als die Querschnitte der dritten Öffnungen L1-L5. Auch dies trägt der unterschiedlichen Viskosität des ersten und zweiten Temperierungsfluids Rechnung und kann bedarfsweise angepasst werden.

Fig. 4a),b) sind jeweilige teilweise senkrechte Querschnittsdarstellungen der Vorrichtung zum Temperieren eines Substrats gemäß der ersten Ausführungsform der vorliegenden Erfindung im Bereich der Öffnungen F1 und L3 zum Einleiten des ersten bzw. zweiten Temperierungsfluids.

In Fig. 4a) ist der Schnittpunkt der ersten Röhre K1F mit dem ersten ringförmigen Kanal R1F der ersten Mehrzahl ringförmiger Kanäle R1F-R4F sowie der Schnittpunkt der dritten Röhre K1L mit dem ersten ringförmigen Kanal R1F der ersten Mehrzahl ringförmiger Kanäle R1F-R4F dargestellt. Da die erste Mehrzahl ringförmiger Kanäle R1F-R4F von der ersten Röhre K1F versorgt wird, ist diese im betreffenden Bereich durch die erste Öffnung F1 der ersten Öffnungen F1-F4 an den ersten ringförmigen Kanal R1F der ersten Mehrzahl ringförmiger Kanäle R1F-R4F angeschlossen, wohingegen die dritte Röhre K1L in diesem Bereich dichtend durchgeführt ist, sodass es zu keiner Vermischung des ersten und zweiten Temperierungsfluids kommen kann. Entsprechendes gilt für die übrigen ersten Öffnungen F2-F4, welche jeweils am zugehörigen Kanal R2F, R3F, R4F der ersten Mehrzahl ringförmiger Kanäle R1F-R4F angeschlossen sind, wohingegen die dritte Röhre K1L in diesen Bereichen ebenfalls dichtend durchgeführt ist.

Entsprechend zeigt Fig. 4b) den Schnittpunkt der ersten Röhre K1F mit dem dritten ringförmigen Kanal R3L der zweiten Mehrzahl ringförmiger Kanäle R1L-R5L, wo die erste Röhre dichtend hindurchgeführt ist. Die dritte Röhre K1L ist in diesem Bereich durch die dritte Öffnung L3 der dritten Öffnungen L1-L5 geöffnet, damit das zweite Temperierungsfluid in den dritten ringförmigen Kanal R3L der zweiten Mehrzahl ringförmiger Kanäle R1L-R5L fließen kann. Entsprechendes gilt für die übrigen dritten Öffnungen L2-L5, welche jeweils am zugehörigen Kanal R2L, R3L, R4L, R5L der zweiten Mehrzahl ringförmiger Kanäle R1L-R5L angeschlossen sind, wohingegen die erste Röhre K1F in diesen Bereichen ebenfalls dichtend durchgeführt ist.

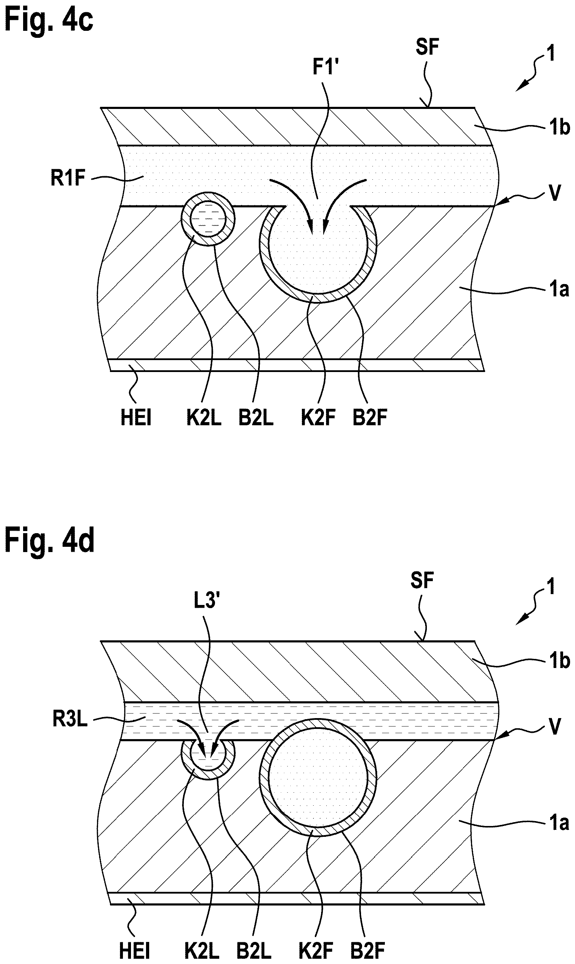

Fig. 4c),d) sind jeweilige teilweise senkrechte Querschnittsdarstellungen der Vorrichtung zum Temperieren eines Substrats gemäß der ersten Ausführungsform der vorliegenden Erfindung im Bereich der Öffnungen F1' und L3' zum Ableiten des ersten bzw. zweiten Temperierungsfluids.

Eine analoge Darstellung zeigt Fig. 4c) für das Abführen des ersten Temperierungsfluids am Schnittpunkt der vierten Röhre K2L und zweiten Röhre K2F mit dem ersten ringförmigen Kanal R1F der ersten Mehrzahl ringförmiger Kanäle R1F-R4F, wo das erste Temperierungsfluid durch die erste Öffnung F1' abgeführt werden kann und die vierte Röhre K2L dichtend durchgeführt ist. Entsprechendes gilt für die übrigen dritten Öffnungen F2-F4, welche jeweils am zugehörigen Kanal R2F, R3F, Rf4 der ersten Mehrzahl ringförmiger Kanäle R1F-R4F angeschlossen sind, wohingegen die vierte Röhre K2L in diesen Bereichen ebenfalls dichtend durchgeführt ist.

Fig. 4d) schließlich zeigt den Schnittpunkt der vierten Röhre K2L mit dem dritten ringförmigen Kanal der zweiten Mehrzahl ringförmiger Kanäle R1L-R5L und den entsprechenden Schnittbereich der zweiten Röhre K2F. Hier wird das zweite Temperierungsfluid in die vierte Röhre K2L durch die dritte Öffnung L3' abgeführt, wohingegen die zweite Röhre dichtend durchgeführt ist.

Entsprechendes gilt für die übrigen dritten Öffnungen L1'-L5', welche jeweils am zugehörigen Kanal R1L-R4L der zweiten Mehrzahl ringförmiger Kanäle R1L-R4L angeschlossen sind, wohingegen die zweite Röhre K2F in diesen Bereichen ebenfalls dichtend durchgeführt ist.

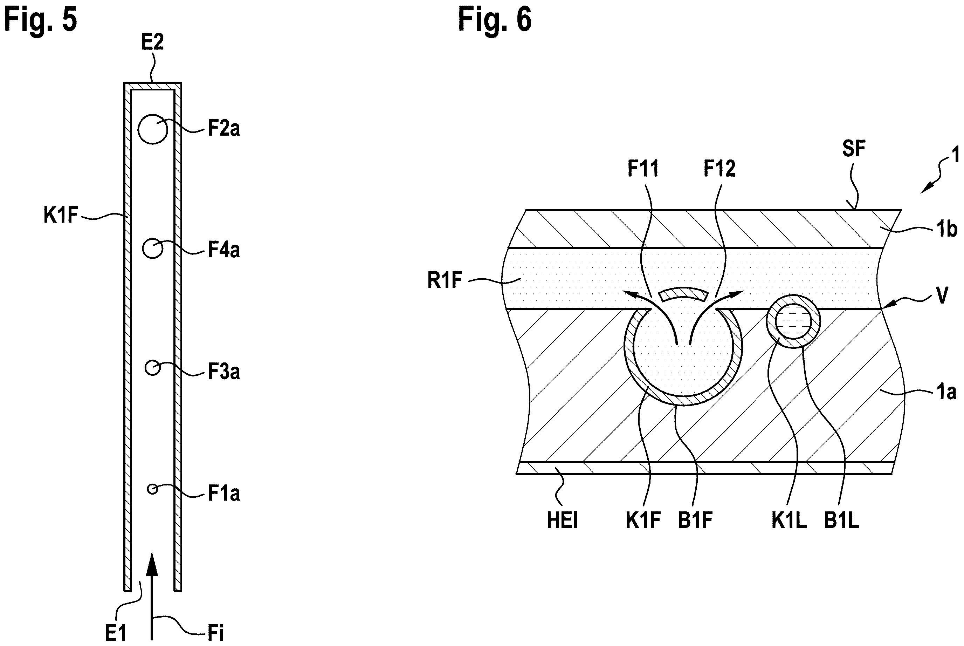

Fig. 5 ist ein axiale Querschnittsdarstellung der ersten Röhre der Vorrichtung zum Temperieren eines Substrats gemäß einer zweiten Ausführungsform der vorliegenden Erfindung.

Bei der zweiten Ausführungsform gemäß Fig. 5 ist dargestellt, dass die ersten Öffnungen F1a, F2a, F3a, F4a der ersten Röhre K1F unterschiedliche Querschnitte aufweisen, wobei die Querschnitte der Öffnungen F1a, F2a, F3a, F4a vom ersten offenen Ende E1 zum zweiten offenen Ende E2 hin ansteigen. Dies trägt dem abnehmenden Staudruck des ersten Temperierungsfluids Rechnung.

Fig. 6 ist eine teilweise senkrechte Querschnittsdarstellung der Vorrichtung zum Tem-perieren eines Substrats gemäß einer dritten Ausführungsform der vorliegenden Erfindung im Bereich der Öffnungen F11 und L12 zum Einleiten des ersten Temperierungsfluids.

Bei der dritten Ausführungsform gemäß Fig. 6 ist eine Modifikation dargestellt, bei der die erste Röhre K1F mehrere Öffnungen F11, F12 pro ringförmigem Kanal R1F-R4F der ersten Mehrzahl ringförmiger Kanäle R1F-R4F aufweist. So lassen sich die Ausströmrichtungen des ersten Temperierungsfluids beeinflussen und insbesondere sogenannte Hotspots oberhalb der Röhre im Oberteil 1b vermeiden.

Bei vorliegendem Beispiel sind die Öffnungen F11 und F12 in gegenüberliegenden Richtungen des zugehörigen ringförmigen Kanals ausgerichtet.

Zur Herstellung der gezeigten Ausführungsformen der Vorrichtung zum Temperieren eines Substrats, insbesondere eines Wafersubstrats, werden vorzugsweise zunächst die Bohrungen B1F, B2F, B1L, B2L in das Unterteil 1a des Hauptkörpers eingebracht und anschließend die erste bis vierte Röhre K1F, K2F, K1L, K4L darin entsprechend eingesetzt, ausgerichtet und abgedichtet.

Weiterhin werden die erste und zweite Mehrzahl ringförmiger Kanäle R1F-R4F und R1L-R5L in das Oberteil 1b eingefräst. Anschließend erfolgt ein Ausrichten und Zusammensetzen sowie Verkleben oder Verlöten im Verbindungsbereich V, was letztlich zur oben beschriebenen Vorrichtung führt.

Eine alternative Herstellungsmöglichkeit würde darin bestehen, dass der Hauptkörper mittels eines dreidimensionalen Druckverfahrens hergestellt wird, wobei beispielsweise in einem Zwischenschritt nach Fertigstellung des Unterteils 1a die erste bis vierte Röhre K1F, K2F, K1L, K2L eingesetzt werden.

Obwohl die vorliegende Erfindung vorstehend anhand bevorzugter Ausführungsformen erläutert wurde, ist sie nicht darauf beschränkt, sondern in vielfältiger Weise modifizierbar.

Die ersten bis vierten Bohrungen B1F, B2F, B1L, B2L sind im vorliegenden Fall als Sackbohrungen gebildet, allerdings ist die Erfindung darauf nicht beschränkt, sondern diese Bohrung können auch durchgehend gebildet werden und die Röhren K1F, K2F, K1L, K2L entweder beidseitig offen mit jeweils zwei Anschlüssen oder wie oben nur einseitig offen ausgebildet werden

Insbesondere ist auch die geometrische Form der Vorrichtung zum Temperieren des Substrats nicht auf eine runde Form beschränkt, sondern kann beliebige Geometrien annehmen. Auch sind die angegebenen Materialien nur beispielhaft und können in breitem Umfang variiert werden. Auch die geometrische Ausführung des Kanalsystems ist beliebig modifizierbar.

Der Schutzbereich des europäischen Patents und der europäischen Patentanmeldung wird durch die Patentansprüche bestimmt. Die Beschreibung und die Zeichnungen sind jedoch zur Auslegung der Patentansprüche heranzuziehen.

## Patentansprüche

1. Vorrichtung zum Temperieren eines Substrats, insbesondere eines Wafersubstrats, mit:
einem plattenförmigen Hauptkörper (1; 1a, 1b) mit einer Substratauflagefläche (SF);
einer ersten Temperierungseinrichtung zum Temperieren des Hauptkörpers mittels eines ersten Temperierungsfluids, welche eine erste Mehrzahl getrennter ringförmiger Kanäle (R1F-R4F) im Innern des Hauptkörpers (1; 1a, 1b) zum Zirkulieren des ersten Temperierungsfluids aufweist;
einer zweiten Temperierungseinrichtung zum Temperieren des Hauptkörpers mittels eines zweiten Temperierungsfluids, welche eine zweite Mehrzahl getrennter ringförmiger Kanäle (R1L-R5L) im Innern des Hauptkörpers (1; 1a, 1b) zum Zirkulieren des zweiten Temperierungsfluids aufweist;
wobei die erste Mehrzahl getrennter ringförmiger Kanäle (R1F-R4F) und die zweite Mehrzahl getrennter ringförmiger Kanäle (R1L-R5L) einander umgreifend alternierend angeordnet sind;
wobei der ersten Mehrzahl ringförmiger Kanäle (R1F-R4F) das erste Temperierungsfluid durch eine erste Röhre (K1F) zuführbar ist und durch eine zweite Röhre (K2F) daraus ableitbar ist;
wobei der zweiten Mehrzahl ringförmiger Kanäle (R1L-R5L) das zweite Temperierungsfluid durch eine dritte Röhre (K1L) zuführbar ist und durch eine vierte Röhre (K2L) daraus ableitbar ist;
wobei der Hauptkörper (1; 1a, 1b) eine erste bis vierte Bohrung (B1F, B2F, B1L, B2L) aufweist, welche jeweils mit der ersten Mehrzahl getrennter ringförmiger Kanäle (R1F-R4F) und der zweiten Mehrzahl getrennter ringförmiger Kanäle (R1L-R5L) kommunizieren;
wobei die erste Röhre (K1F) in die erste Bohrung (B1F) des Hauptkörpers (1; 1a, 1b) eingesetzt ist und jeweilige erste Öffnungen (F1-F4) im Bereich der ersten Mehrzahl getrennter ringförmiger Kanäle (R1F-R4F) zum Zuführen des ersten Temperierungsfluids aufweist;
wobei die zweite Röhre (K2F) in die zweite Bohrung (B2F) des Hauptkörpers (1; 1a, 1b) eingesetzt ist und jeweilige zweite Öffnungen (F1'-F4') im Bereich der ersten Mehrzahl getrennter ringförmiger Kanäle (R1F-R4F) zum Abführen des ersten Temperierungsfluids aufweist;
wobei die dritte Röhre (K1L) in die dritte Bohrung (B1L) des Hauptkörpers (1; 1a, 1b) eingesetzt ist jeweilige dritte Öffnungen (L1-L4) im Bereich der zweiten Mehrzahl getrennter ringförmiger Kanäle (R1L-R5L) zum Zuführen des zweiten Temperierungsfluids aufweist;
wobei die vierte Röhre (K2L) in die vierte Bohrung (B2L) des Hauptkörpers (1; 1a, 1b) eingesetzt ist und jeweilige vierte Öffnungen (L1'-L5') im Bereich der zweiten Mehrzahl getrennter ringförmiger Kanäle (R1L-R5L) zum Abführen des zweiten Temperierungsfluids aufweist.

2. Vorrichtung zum Temperieren eines Substrats nach Anspruch 1, wobei der Hauptkörper (1; 1a, 1b) einen plattenförmigen Unterteil (1a) und einen plattenförmigen Oberteil (1b) aufweist, welche in einem Verbindungsbereich (V) miteinander verbunden, insbesondere verlötet oder verklebt, sind.

3. Vorrichtung zum Temperieren eines Substrats nach Anspruch 2, wobei die erste bis vierte Bohrung (B1F, B2F, B1L, B2L) im Unterteil (1a) und die erste Mehrzahl getrennter ringförmiger Kanäle (R1F-R4F) und die zweite Mehrzahl getrennter ringförmiger Kanäle (R1L-R5L) im Oberteil (1b) vorgesehen sind.

4. Vorrichtung zum Temperieren eines Substrats nach einem der vorhergehenden Ansprüche, wobei die erste Mehrzahl getrennter ringförmiger Kanäle (R1F-R4F) und die zweite Mehrzahl getrennter ringförmiger Kanäle (R1L-R5L) konzentrisch zu einer Mittelachse (M) des Hauptkörpers (1; 1a, 1b), vorzugsweise kreisförmig, angeordnet sind.

5. Vorrichtung zum Temperieren eines Substrats nach einem der vorhergehenden Ansprüche, wobei die erste Mehrzahl getrennter ringförmiger Kanäle (R1F-R4F) und die zweite Mehrzahl getrennter ringförmiger Kanäle (R1L-R5L) jeweilige unterschiedliche Querschnitte (Q1, Q2) aufweisen.

6. Vorrichtung zum Temperieren eines Substrats nach einem der vorhergehenden Ansprüche, wobei die erste bis vierte Röhre (K1F, K2F, K1L, K2L) mit dem Hautkörper (1; 1a, 1b) verlötet oder verklebt sind.

7. Vorrichtung zum Temperieren eines Substrats nach einem der vorhergehenden Ansprüche, wobei die erste bis vierte Röhre (K1F, K2F, K1L, K2L) aus Edelstahl, Kupfer oder einem Kunststoff hergestellt sind.

8. Vorrichtung zum Temperieren eines Substrats nach einem der vorhergehenden Ansprüche, wobei der Hauptkörper (1; 1a, 1b) aus Kupfer oder Aluminium hergestellt ist.

9. Vorrichtung zum Temperieren eines Substrats nach einem der vorhergehenden Ansprüche, wobei die ersten Öffnungen (F1-F4) und die zweiten Öffnungen (F1'-F4') paarweise derart angeordnet sind, dass sie mit dem jeweiligen ringförmigen Kanal (R1F-R4F) an zwei Orten kommunizieren, welche im Uhrzeigersinn und im Gegenuhrzeigersinn entlang des jeweiligen ringförmigen Kanals (R1F-R4F) ungefähr gleichweit beabstandet sind.

10. Vorrichtung zum Temperieren eines Substrats nach einem der vorhergehenden Ansprüche, wobei die dritten Öffnungen (L1-L5) und die vierten Öffnungen (L1'-L5') paarweise derart angeordnet sind, dass sie mit dem jeweiligen ringförmigen Kanal (R1L-R5L) an zwei Orten kommunizieren, welche im Uhrzeigersinn und im Gegenuhrzeigersinn entlang des jeweiligen ringförmigen Kanals (R1L-R5L) ungefähr gleichweit beabstandet sind.

11. Vorrichtung zum Temperieren eines Substrats nach einem der vorhergehenden Ansprüche, wobei die erste und/oder zweite und/oder dritte und/oder vierte Röhre (K1F; K2F; K1L; K2F) ein erstes offenes Ende (E1; E1'; E1 "; E1‴) und ein zweites geschlossenes Ende (E2; E2'; E2"; E2‴) aufweisen und die Öffnungen einen vom ersten offenen Ende (E1; E1'; E1"; E1‴) zum zweiten geschlossenen Ende (E2; E2'; E2"; E2‴) hin ansteigenden Querschnitt aufweisen.

12. Vorrichtung zum Temperieren eines Substrats nach einem der vorhergehenden Ansprüche, wobei die erste und/oder zweite und/oder dritte und/oder vierte Röhre (K1F; K2F; K1L; K2F) mehrere Öffnungen (F11, F12) pro ringförmigen Kanal (R1F-R4F; R1L-R4L) aufweisen.

13. Vorrichtung zum Temperieren eines Substrats nach Anspruch 12, wobei die mehreren Öffnungen (F11, F12) in gegenüberliegende Richtungen des zugehörigen ringförmigen Kanals (R1F-R4F; R1L-R4L) ausgerichtet sind.

14. Herstellungsverfahren für eine Vorrichtung zum Temperieren eines Substrats, insbesondere eines Wafersubstrats, mit den Schritten:
Bereitstellen von einem plattenförmigen Hauptkörper (1; 1a, 1b) mit einer Substratauflagefläche (SF);
Ausbilden einer ersten Temperierungseinrichtung zum Temperieren des Hauptkörpers mittels eines ersten Temperierungsfluids, welche eine erste Mehrzahl getrennter ringförmiger Kanäle (R1F-R4F) im Innern des Hauptkörpers (1; 1a, 1b) zum Zirkulieren des ersten Temperierungsfluids aufweist;
Ausbilden einer zweiten Temperierungseinrichtung zum Temperieren des Hauptkörpers mittels eines zweiten Temperierungsfluids, welche eine zweite Mehrzahl getrennter ringförmiger Kanäle (R1L-R5L) im Innern des Hauptkörpers (1; 1a, 1b) zum Zirkulieren des zweiten Temperierungsfluids aufweist;
wobei die erste Mehrzahl getrennter ringförmiger Kanäle (R1F-R4F) und die zweite Mehrzahl getrennter ringförmiger Kanäle (R1L-R5L) einander umgreifend alternierend angeordnet werden;
Bereitstellen einer ersten bis vierten Röhre (K1F, K2F, K1L, K2L), wobei der ersten Mehrzahl ringförmiger Kanäle (R1F-R4F) das erste Temperierungsfluid durch die erste Röhre (K1F) zuführbar ist und durch die zweite Röhre (K2F) daraus ableitbar ist und wobei der zweiten Mehrzahl ringförmiger Kanäle (R1L-R5L) das zweite Temperierungsfluid durch die dritte Röhre (K1L) zuführbar ist und durch die vierte Röhre (K2L) daraus ableitbar ist;
wobei in dem Hauptkörper (1; 1a, 1b) eine erste bis vierte Bohrung (B1F, B2F, B1L, B2L) gebildet wird, welche jeweils mit der ersten Mehrzahl getrennter ringförmiger Kanäle (R1F-R4F) und der zweiten Mehrzahl getrennter ringförmiger Kanäle (R1L-R5L) kommunizieren;
wobei die erste Röhre (K1F) in die erste Bohrung (B1F) des Hauptkörpers (1; 1a, 1b) eingesetzt wird und jeweilige erste Öffnungen (F1-F4) im Bereich der ersten Mehrzahl getrennter ringförmiger Kanäle (R1F-R4F) zum Zuführen des ersten Temperierungsfluids aufweist;
wobei die zweite Röhre (K2F) in die zweite Bohrung (B2F) des Hauptkörpers (1; 1a, 1b) eingesetzt wird und jeweilige zweite Öffnungen (F1'-F4') im Bereich der ersten Mehrzahl getrennter ringförmiger Kanäle (R1F-R4F) zum Abführen des ersten Temperierungsfluids aufweist;
wobei die dritte Röhre (K1L) in die dritte Bohrung (B1L) des Hauptkörpers (1; 1a, 1b) eingesetzt wird und jeweilige dritte Öffnungen (L1-L4) im Bereich der zweiten Mehrzahl getrennter ringförmiger Kanäle (R1L-R5L) zum Zuführen des zweiten Temperierungsfluids aufweist;
wobei die vierte Röhre (K2L) in die vierte Bohrung (B2L) des Hauptkörpers (1; 1a, 1b) eingesetzt wird und jeweilige vierte Öffnungen (L1'-L5') im Bereich der zweiten Mehrzahl getrennter ringförmiger Kanäle (R1L-R5L) zum Abführen des zweiten Temperierungsfluids aufweist.

15. Herstellungsverfahren nach Anspruch 14, wobei der Hauptkörper (1; 1a, 1b) einen plattenförmigen Unterteil (1a) und einen plattenförmigen Oberteil (1b) aufweist, welche in einem Verbindungsbereich (V) miteinander verbunden, insbesondere verlötet oder verklebt, werden.

16. Herstellungsverfahren nach Anspruch 15, wobei die erste bis vierte Bohrung (B1F, B2F, B1L, B2L) im Unterteil (1a) und die erste Mehrzahl getrennter ringförmiger Kanäle (R1F-R4F) und die zweite Mehrzahl getrennter ringförmiger Kanäle (R1L-R5L) im Oberteil (1b) vorgesehen werden und die erste bis vierte Röhre (K1F, K2F, K1L, K2L) eingesetzt werden, bevor der plattenförmige Unterteil (1a) und der plattenförmigen Oberteil (1b) miteinander verbunden werden.

17. Herstellungsverfahren nach einem der Ansprüche 14 bis 16, wobei die erste bis vierte Röhre (K1F, K2F, K1L, K2L) mit dem Hautkörper (1; 1a, 1b) verlötet oder verklebt werden.

18. Herstellungsverfahren nach einem der Ansprüche 14 bis 16, wobei der Hauptkörper (1; 1a, 1b) mittels eines dreidimensionalen Druckverfahrens hergestellt wird.

19. Herstellungsverfahren nach einem der Ansprüche 14 bis 18, wobei die erste und/oder zweite und/oder dritte und/oder vierte vierte Bohrung (B1F, B2F, B1L, B2L) als Sackbohrung gebildet werden und die erste und/oder zweite und/oder dritte und/oder vierte Röhre (K1F; K2F; K1L; K2F) ein erstes offenes Ende (E1; E1'; E1"; E1‴) und ein zweites geschlossenes Ende (E2; E2'; E2"; E2‴) aufweisen.

## Claims

1. Apparatus for tempering a substrate, in particular a wafer substrate, having:
a plate-shaped main body (1; 1a, 1b) having a substrate bearing surface (SF);
a first tempering device for tempering the main body by means of a first tempering fluid and said first tempering device comprises a first plurality of separate annular ducts (R1F-R4F) in the interior of the main body (1; 1a, 1b) for circulating the first tempering fluid;
a second tempering device for tempering the main body by means of a second tempering fluid and said second tempering device comprises a second plurality of separate annular ducts (R1L-R5L) in the interior of the main body (1; 1a, 1b) for circulating the second tempering fluid;
wherein the first plurality of separate annular ducts (R1F-R4F) and the second plurality of separate annular ducts (R1L-R5L) are arranged alternately encompassing one another;
wherein it is possible to supply the first tempering fluid to the first plurality of annular ducts (R1F-R4F) through a first tube (K1F) and it is possible through a second tube (K2F) to drain said first tempering fluid from said first plurality of annular ducts,
wherein it is possible to supply the second tempering fluid to the second plurality of annular ducts (R1L-R5L) through a third tube (K1L) and it is possible through a fourth tube (K2L) to drain said second tempering fluid from said second plurality of annular ducts;
wherein the main body (1; 1a, 1b) comprises a first to fourth hole (B1F, B2F, B1L, B2L) and said holes in each case communicate with the first plurality of separate annular ducts (R1F-R4F) and the second plurality of separate annular ducts (R1L-R5L);
wherein the first tube (K1F) is inserted into the first hole (B1F) of the main body (1: 1a, 1b) and comprises respective first openings (F1-F4) in the region of the first plurality of separate annular ducts (R1F-R4F) for supplying the first tempering fluid;
wherein the second tube (K2F) is inserted into the second hole (B2F) of the main body (1: 1a, 1b) and comprises respective second openings (F1'-F4') in the region of the first plurality of separate annular ducts (R1F-R4F) for draining the first tempering fluid;
wherein the third tube (K1L) is inserted into the third hole (B1L) of the main body (1: 1a, 1b) comprises respective third openings (L1-L4) in the region of the second plurality of separate annular ducts (R1L-R5L) for supplying the second tempering fluid;
wherein the fourth tube (K2L) is inserted into the fourth hole (B2L) of the main body (1: 1a, 1b) and comprises respective fourth openings (L1'-L5') in the region of the second plurality of separate annular ducts (R1L-R5L) for draining the second tempering fluid.

2. Apparatus for tempering a substrate according to claim 1, wherein the main body (1; 1a, 1b) comprises a plate-shaped lower part (1a) and a plate-shaped upper part (1b) that are connected to one another, in particular soldered or adhesively bonded, in a connecting region (V).

3. Apparatus for tempering a substrate according to claim 2, wherein the first to fourth hole (B1F, B2F, B1L, B2L) are provided in the lower part (1a) and the first plurality of separate annular ducts (R1F-R4F) and the second plurality of separate annular ducts (R1L-R5L) are provided in the upper part (1b).

4. Apparatus for tempering a substrate according to one of the preceding claims, wherein the first plurality of separate annular ducts (R1F-R4F) and the second plurality of separate annular ducts (R1L-R5L) are arranged, preferably in a circular manner, concentrically with respect to a central axis (M) of the main body (1; 1a, 1b) .

5. Apparatus for tempering a substrate according to one of the preceding claims, wherein the first plurality of separate annular ducts (R1F-R4F) and the second plurality of separate annular ducts (R1L-R5L) comprise respective different cross sections (Q1, Q2).

6. Apparatus for tempering a substrate according to one of the preceding claims, wherein the first to fourth tube (K1F, K2F, K1L, K2L) are soldered or adhesively bonded to the main body (1; 1a, 1b).

7. Apparatus for tempering a substrate according to one of the preceding claims, wherein the first to fourth tube (K1F, K2F, K1L, K2L) are produced from stainless steel, copper or a synthetic material.

8. Apparatus for tempering a substrate according to one of the preceding claims, wherein the main body (1; 1a, 1b) is produced from copper or aluminium.

9. Apparatus for tempering a substrate according to one of the preceding claims, wherein the first openings (F1-F4) and the second openings (F1'-F4') are arranged in pairs in such a manner that said first and second openings communicate with the respective annular duct (R1F-R4F) at two locations that are spaced approximately equidistant in the clockwise direction and in the counterclockwise direction along the respective annular duct (R1F-R4F).

10. Apparatus for tempering a substrate according to one of the preceding claims, wherein the third openings (L1-L5) and the fourth openings (L1'-L5') are arranged in pairs in such a manner that said third and fourth openings communicate with the respective annular duct (R1L-R5L) at two locations that are spaced approximately equidistant in the clockwise direction and in the counterclockwise direction along the respective annular duct (R1L-R5L).

11. Apparatus for tempering a substrate according to one of the preceding claims, wherein the first and/or second and/or third and/or fourth tube (K1F; K2F; K1L; K2F) comprise a first open end (E1; E1'; E1"; E1‴) and a second closed end (E2; E2'; E2"; E2‴) and the openings comprise a cross section that increases from the first open end (E1; E1'; E1"; E1‴) to the second closed end (E2; E2'; E2"; E2‴).

12. Apparatus for tempering a substrate according to one of the preceding claims, wherein the first and/or second and/or third and/or fourth tube (K1F; K2F; K1L; K2F) comprise multiple openings (F11, F12) per annular duct (R1F-R4F; R1L-R4L).

13. Apparatus for tempering a substrate according to claim 12, wherein the multiple openings (F11, F12) are oriented in opposite directions of the associated annular duct (R1F-R4F; R1L-R4L).

14. Production method for an apparatus for tempering a substrate, in particular a wafer substrate, having the steps:
providing a plate-shaped main body (1; 1a, 1b) having a substrate supporting surface (SF);
forming a first tempering device for tempering the main body by means of a first tempering fluid and said tempering device comprises a first plurality of separate annular ducts (R1F-R4F) in the interior of the main body (1; 1a, 1b) for circulating the first tempering fluid;
forming a second tempering device for tempering the main body by means of a second tempering fluid and said tempering device comprises a second plurality of separate annular ducts (R1L-R5L) in the interior of the main body (1; 1a, 1b) for circulating the second tempering fluid;
wherein the first plurality of separate annular ducts (R1F-R4F) and the second plurality of separate annular ducts (R1L-R5L) are arranged alternately encompassing one another;
providing a first to fourth tube 9 (K1F, K2F, K1L, K2L), wherein it is possible to supply the first tempering fluid to the first plurality of annular ducts (R1F-R4F) through the first tube (K1F) and it is possible through the second tube (K2F) to drain said first tempering fluid from said first plurality of annular ducts and wherein it is possible to supply the second tempering fluid to the second plurality of annular ducts (R1L-R5L) through the third tube (K1L) and it is possible through the fourth tube (K2L) to drain said tempering fluid from said second plurality of annular ducts;
wherein a first to fourth hole (B1F, B2F, B1L, B2L) is formed in the main body (1; 1a, 1b) and said holes in each case communicate with the first plurality of separate annular ducts (R1F-R4F) and the second plurality of separate annular ducts (R1L-R5L);
wherein the first tube (K1F) is inserted into the first hole (B1F) of the main body (1: 1a, 1b) and comprises respective first openings (F1-F4) in the region of the first plurality of separate annular ducts (R1F-R4F) for supplying the first tempering fluid;
wherein the second tube (K2F) is inserted into the second hole (B2F) of the main body (1: 1a, 1b) and comprises respective second openings (F1'-F4') in the region of the first plurality of separate annular ducts (R1F-R4F) for draining the first tempering fluid;
wherein the third tube (K1L) is inserted into the third hole (B1L) of the main body (1: 1a, 1b) and comprises respective third openings (L1-L4) in the region of the second plurality of separate annular ducts (R1L-R5L) for supplying the second tempering fluid;
wherein the fourth tube (K2L) is inserted into the fourth hole (B2L) of the main body (1: 1a, 1b) and comprises respective fourth openings (L1'-L5') in the region of the second plurality of separate annular ducts (R1L-R5L) for draining the second tempering fluid.

15. Production method according to claim 14, wherein the main body (1; 1a, 1b) comprises a plate-shaped lower part (1a) and a plate-shaped upper part (1b) that are connected to one another, in particular soldered or adhesively bonded, in a connecting region (V).

16. Production method according to claim 15, wherein the first to fourth hole (B1F, B2F, B1L, B2L) are provided in the lower part (1a) and the first plurality of separate annular ducts (R1F-R4F) and the second plurality of separate annular ducts (R1L-R5L) are provided in the upper part (1b) and the first to fourth tube (K1F, K2F, K1L, K2L) are inserted before the plate-shaped lower part (1a) and the plate-shaped upper part (1b) are connected to one another.

17. Production method according to one of claims 14 to 16, wherein the first to fourth tube (K1F, K2F, K1L, K2L) are soldered or adhesively bonded to the main body (1; 1a, 1b).

18. Production method according to one of claims 14 to 16, wherein the main body (1; 1a, 1b) is produced by means of a 3D printing method.

19. Production method according to one of claims 14 to 18, wherein the first and/or second and/or third and/or fourth hole (B1F, B2F, B1L, B2L) are formed as blind holes and the first and/or second and/or third and/or fourth tube (K1F, K2F, K1L, K2F) comprise a first open end (E1; E1'; E1"; E1‴) and a second closed end (E2; E2' ; E2" ; E2‴).

## Revendications

1. Dispositif pour réguler la température d'un substrat, en particulier un substrat de plaquette, présentant :
un corps principal en forme de plaque (1 ; 1a, 1b) avec une surface porteuse de substrat (SF) ;
un premier moyen de régulation de température pour réguler la température du corps principal au moyen d'un premier fluide de régulation de température, qui présente une première pluralité de canaux annulaires séparés (R1F-R4F) à l'intérieur du corps principal (1 ; 1a, 1b) pour faire circuler le premier fluide de régulation de température ;
un deuxième moyen de régulation de température pour réguler la température du corps principal au moyen d'un deuxième fluide de régulation de température, qui présente une deuxième pluralité de canaux annulaires séparés (R1L-R5L) à l'intérieur du corps principal (1 ; 1a, 1b) pour faire circuler le deuxième fluide de régulation de température ;
dans lequel la première pluralité de canaux annulaires séparés (R1F-R4F) et la deuxième pluralité de canaux annulaires séparés (R1L-R5L) sont disposées en alternance les uns autour des autres ;
dans lequel le premier fluide de régulation de température peut être amené à la première pluralité de canaux annulaires (R1F-R4F) par un premier tube (K1F) et peut en être évacué par un deuxième tube (K2F) ;
dans lequel le deuxième fluide de régulation de température peut être amené à la deuxième pluralité de canaux annulaires (R1L-R5L) par un troisième tube (K1L) et peut en être évacué par un quatrième tube (K2L) ;
dans lequel le corps principal (1 ; 1a, 1b) présente des premier à quatrième alésages (B1F, B2F, B1L, B2L) qui communiquent respectivement avec la première pluralité de canaux annulaires séparés (R1F-R4F) et la deuxième pluralité de canaux annulaires séparés (R1L-R5L) ;
dans lequel le premier tube (K1F) est inséré dans le premier alésage (B1F) du corps principal (1 ; 1a, 1b) et présente des premières ouvertures respectives (F1-F4) dans la zone de la première pluralité de canaux annulaires séparés (R1F-R4F) pour l'amenée du premier fluide de régulation de température ;
dans lequel le deuxième tube (K2F) est inséré dans le deuxième alésage (B2F) du corps principal (1 ; 1a, 1b) et présente des deuxièmes ouvertures respectives (F1'-F4') dans la zone de la première pluralité de canaux annulaires séparés (R1F-R4F) pour l'évacuation du premier fluide de régulation de température ;
dans lequel le troisième tube (K1L) est inséré dans le troisième alésage (B1L) du corps principal (1 ; 1a, 1b) présente des troisièmes ouvertures respectives (L1-L4) dans la zone de la deuxième pluralité de canaux annulaires séparés (R1L-R5L) pour l'amenée du deuxième fluide de régulation de température ;
dans lequel le quatrième tube (K2L) est inséré dans le quatrième alésage (B2L) du corps principal (1 ; 1a, 1b) et présente des quatrièmes ouvertures respectives (L1'-L5') dans la zone de la deuxième pluralité de canaux annulaires séparés (R1L-R5L) pour l'évacuation du deuxième fluide de régulation de température.

2. Dispositif pour réguler la température d'un substrat selon la revendication 1, dans lequel le corps principal (1 ; 1a, 1b) présente une partie inférieure (1a) en forme de plaque et une partie supérieure (1b) en forme de plaque qui sont reliées l'une à l'autre, en particulier soudées ou collées, dans une zone de liaison (V).

3. Dispositif pour réguler la température d'un substrat selon la revendication 2, dans lequel les premier à quatrième alésages (B1F, B2F, B1L, B2L) sont prévus dans la partie inférieure (1a) et la première pluralité de canaux annulaires séparés (R1F-R4F) et la deuxième pluralité de canaux annulaires séparés (R1L-R5L) sont prévus dans la partie supérieure (1b).

4. Dispositif pour réguler la température d'un substrat selon l'une des revendications précédentes, dans lequel la première pluralité de canaux annulaires séparés (R1F-R4F) et la deuxième pluralité de canaux annulaires séparés (R1L-R5L) sont disposés de manière concentrique à un axe central (M) du corps principal (1 ; 1a, 1b), de préférence de manière circulaire.

5. Dispositif pour réguler la température d'un substrat selon l'une des revendications précédentes, dans lequel la première pluralité de canaux annulaires séparés (R1F-R4F) et la deuxième pluralité de canaux annulaires séparés (R1L-R5L) ont des sections transversales respectives (Q1, Q2) différentes.

6. Dispositif pour réguler la température d'un substrat selon l'une des revendications précédentes, dans lequel les premier à quatrième tubes (K1F, K2F, K1L, K2L) sont soudés ou collés au corps principal (1 ; 1a, 1b).

7. Dispositif pour réguler la température d'un substrat selon l'une des revendications précédentes, dans lequel les premier à quatrième tubes (K1F, K2F, K1L, K2L) sont fabriqués en acier inoxydable, en cuivre ou en matière plastique.

8. Dispositif pour réguler la température d'un substrat selon l'une des revendications précédentes, dans lequel le corps principal (1 ; 1a, 1b) est fabriqué en cuivre ou en aluminium.

9. Dispositif pour réguler la température d'un substrat selon l'une des revendications précédentes, dans lequel les premières ouvertures (F1-F4) et les deuxièmes ouvertures (F1'-F4') sont disposés par paires de manière à communiquer avec le canal annulaire respectif (R1F-R4F) en deux endroits qui sont à peu près équidistants dans le sens horaire et dans le sens antihoraire le long du canal annulaire respectif (R1F-R4F).

10. Dispositif pour réguler la température d'un substrat selon l'une des revendications précédentes, dans lequel les troisièmes ouvertures (L1-L5) et les quatrièmes ouvertures (L1'-L5') sont disposées par paires de manière à communiquer avec le canal annulaire respectif (R1L-R5L) en deux endroits qui sont à peu près équidistants dans le sens horaire et dans le sens antihoraire le long du canal annulaire respectif (R1L-R5L).

11. Dispositif pour réguler la température d'un substrat selon l'une des revendications précédentes, dans lequel le premier et/ou le deuxième et/ou le troisième et/ou le quatrième tube (K1F ; K2F ; K1L ; K2F) présentent une première extrémité ouverte (E1 ; E1'; E1" ; E1‴) et une deuxième extrémité fermée (E2 ; E2' ; E2" ; E2‴) et les ouvertures présentent une section transversale qui augmente de la première extrémité ouverte (E1 ; E1'; E1" ; E1‴) vers la deuxième extrémité fermée (E2 ; E2' ; E2" ; E2‴).

12. Dispositif pour réguler la température d'un substrat selon l'une des revendications précédentes, dans lequel le premier et/ou le deuxième et/ou le troisième et/ou le quatrième tube (K1F ; K2F ; K1L ; K2F) présentent plusieurs ouvertures (F11, F12) par canal annulaire (R1F-R4F ; R1L-R4L).

13. Dispositif pour réguler la température d'un substrat selon la revendication 12, dans lequel lesdites plusieurs ouvertures (F11, F12) sont orientées dans des directions opposées du canal annulaire associé (R1F-R4F ; R1L-R4L).

14. Procédé de fabrication d'un dispositif pour réguler la température d'un substrat, en particulier d'un substrat de plaquette, comprenant les étapes consistant à :
mettre à disposition un corps principal en forme de plaque (1 ; 1a, 1b) avec une surface porteuse de substrat (SF) ;
former un premier moyen de régulation de température pour réguler la température du corps principal au moyen d'un premier fluide de régulation de température, qui présente une première pluralité de canaux annulaires séparés (R1F-R4F) à l'intérieur du corps principal (1 ; 1a, 1b) pour faire circuler le premier fluide de régulation de température ;
former un deuxième moyen de régulation de température pour réguler la température du corps principal au moyen d'un deuxième fluide de régulation de température, qui présente une deuxième pluralité de canaux annulaires séparés (R1L-R5L) à l'intérieur du corps principal (1 ;
1a, 1b) pour faire circuler le deuxième fluide de régulation de température ;
dans lequel la première pluralité de canaux annulaires séparés (R1F-R4F) et la deuxième pluralité de canaux annulaires séparés (R1L-R5L) sont disposés en alternance les uns autour des autres ;
mettre à disposition des premier à quatrième tubes (K1F, K2F, K1L, K2L), dans lequel le premier fluide de régulation de température peut être amené à la première pluralité de canaux annulaires (R1F-R4F) par le premier tube (K1F) et peut en être évacué par le deuxième tube (K2F), et dans lequel le deuxième fluide de régulation de température peut être amené à la deuxième pluralité de canaux annulaires (R1L-R5L) par le troisième tube (K1L) et peut en être évacué par le quatrième tube (K2L) ;
dans lequel des premier à quatrième alésages (B1F, B2F, B1L, B2L) sont formés dans le corps principal (1 ; 1a,
1b) qui communiquent respectivement avec la première pluralité de canaux annulaires séparés (R1F-R4F) et la deuxième pluralité de canaux annulaires séparés (R1L-R5L) ;
dans lequel le premier tube (K1F) est inséré dans le premier alésage (B1F) du corps principal (1 ; 1a, 1b) et présente des premières ouvertures respectives (F1-F4) dans la zone de la première pluralité de canaux annulaires séparés (R1F-R4F) pour l'amenée du premier fluide de régulation de température ;
dans lequel le deuxième tube (K2F) est inséré dans le deuxième alésage (B2F) du corps principal (1 ; 1a, 1b) et présente des deuxièmes ouvertures respectives (F1'-F4') dans la zone de la première pluralité de canaux annulaires séparés (R1F-R4F) pour l'évacuation du premier fluide de régulation de température ;
dans lequel le troisième tube (K1L) est inséré dans le troisième alésage (B1L) du corps principal (1 ; 1a, 1b) et présente des troisièmes ouvertures respectives (L1-L4) dans la zone de la deuxième pluralité de canaux annulaires séparés (R1L-R5L) pour l'amenée du deuxième fluide de régulation de température ;
dans lequel le quatrième tube (K2L) est inséré dans le quatrième alésage (B2L) du corps principal (1 ; 1a, 1b) et présente des quatrièmes ouvertures respectives (L1'-L5') dans la zone de la deuxième pluralité de canaux annulaires séparés (R1L-R5L) pour l'évacuation du deuxième fluide de régulation de température.

15. Procédé de fabrication selon la revendication 14, dans lequel le corps principal (1 ; 1a, 1b) présente une partie inférieure (1a) en forme de plaque et une partie supérieure (1b) en forme de plaque qui sont reliées l'une à l'autre, en particulier soudées ou collées, dans une zone de liaison (V).

16. Procédé de fabrication selon la revendication 15, dans lequel les premier à quatrième alésages (B1F, B2F, B1L, B2L) sont prévus dans la partie inférieure (1a) et la première pluralité de canaux annulaires séparés (R1F-R4F) et la deuxième pluralité de canaux annulaires séparés (R1L-R5L) sont prévus dans la partie supérieure (1b) et les premier à quatrième tubes (K1F, K2F, K1L, K2L) sont insérés avant que la partie inférieure (1a) en forme de plaque et la partie supérieure (1b) en forme de plaque ne soient reliées l'une à l'autre.

17. Procédé de fabrication selon l'une des revendications 14 à 16, dans lequel les premier à quatrième tubes (K1F, K2F, K1L, K2L) sont soudés ou collés au corps principal (1 ; 1a, 1b).

18. Procédé de fabrication selon l'une des revendications 14 à 16, dans lequel le corps principal (1 ; 1a, 1b) est fabriqué par un procédé d'impression tridimensionnelle.

19. Procédé de fabrication selon l'une des revendications 14 à 18, dans lequel le premier et/ou le deuxième et/ou le troisième et/ou le quatrième alésage (B1F, B2F, B1L, B2L) sont formés comme des alésages borgnes et le premier et/ou le deuxième et/ou le troisième et/ou le quatrième tube (K1F ; K2F ; K1L ; K2F) présentent une première extrémité ouverte (E1 ; E1' ; E1" ; E1‴) et une deuxième extrémité fermée (E2 ; E2' ; E2" ; E2‴).
